# EUROPÄISCHE PATENTANMELDUNG

(11) **EP 1 916 530 A1**
(43) Veröffentlichungstag der Anmeldung: **30.04.2008**
(21) Anmeldenummer: 07020995.2
(22) Anmeldetag: 26.10.2007
(51) Int. Cl.: G01R 27/16, H02J 13/00

(54) **Vorrichtung und Verfahren zur Messung der Netzimpedanz auf der Mittelspannungsebene**

(30) Priorität: 27.10.2006 DE 102006050766
(71) Anmelder: Helmut-Schmidt-Universität Hamburg, 22043 Hamburg (DE)
(72) Erfinder: Schulz, Detlef, Prof. Dr. Ing., 10557 Berlin (DE)
(74) Vertreter: Schildberg, Peter

(57) **Zusammenfassung**

Vorrichtung zur Messung der Impedanz eines elektrischen Vorsorgungsnetzes auf der Mittelspannungsebene (10), die folgendes aufweist:
- einen Meßtransformator (16), der in mindestens einem Frequenzbereich ein lineares Frequenzverhalten aufweist, oder
- eine Reihenschaltung mehrerer leistungselektronischer Schalteinrichtungen,
- eine Impedanz (22), die über ein zusätzliches Schaltelement (20) sekundärseitig an den Meßtransformator oder die Reihenschaltung schaltbar ist, und
- einen Stromwandler (26) und einen Spannungswandler (24), die mit dem Meßtransformator oder der Reihenschaltung verbunden sind.

## Beschreibung

Die vorliegende Erfindung betrifft eine Vorrichtung und ein Verfahren zur Messung der Impedanz eines elektrischen Versorgungsnetzes auf der Mittelspannungsebene.

Bekanntermaßen ist das elektrische Versorgungsnetz mit unterschiedlichen Spannungsebenen aufgebaut. So kann beispielsweise ein 110 kV-Netz über einen ersten Transformator von der Hochspannungsebene auf die Mittelspannungsebene transformiert werden. Hierbei kann es sich beispielsweise um einen Transformator handeln, der 110 kV in 10 kV transformiert. Auf der Mittelspannungsebene kann die elektrische Leistung weiter im Netz verteilt werden. Über einen zweiten Transformator wird die Mittelspannung auf Niederspannung umgesetzt, so beispielsweise von 10 kV auf 400 V. Die Impedanzen der einzelnen Spannungsebenen unterscheiden sich aufgrund der in den Ebenen eingesetzten Betriebsmittel.

Zur Planung von Elektroenergieanlagen und zur Entscheidung über den Anschluß zusätzlicher Lasten sind Kenntnisse über die frequenzabhängige Netzimpedanz erforderlich. Bisher sind nur Verfahren und Geräte zur Impedanzmessung auf der Niederspannungsebene bekannt. Bei bekannten Meßgeräten zur Messung auf der Niederspannungsebene wird beispielsweise eine definierte Impedanz gepulst an das Netz geschaltet. Der durch den fließenden Netzstrom auftretende Spannungsabfall wird dann auf der Niederspannungsseite gemessen und in seinem Frequenzspektrum analysiert.

Auf der Mittelspannungsebene ist eine direkte Anregung des Netzes aufgrund der höheren Spannung nur mit erheblichem Aufwand möglich. So sind beispielsweise die Gerätedimension für die Isolierungsabstände und die Sicherheitsvorschriften zu berücksichtigen.

Der Erfindung liegt die Aufgabe zugrunde, eine Vorrichtung und ein Verfahren zur Messung der Netzimpedanz auf Mittelspannungsebene bereitzustellen, die bzw. das mit einfachen Mitteln lokal zuverlässige Meßergebnisse liefert.

Erfindungsgemäß wird die Aufgabe durch eine Vorrichtung mit den Merkmalen aus Anspruch 1 und durch ein Verfahren mit den Merkmalen aus Anspruch 8 gelöst. Vorteilhafte Ausgestaltungen der Erfindung bilden die Gegenstände der abhängigen Ansprüche.

Erfindungsgemäß dient die Vorrichtung zur Messung der Impedanz eines elektrischen Versorgungsnetzes auf der Mittelspannungsebene. Die Vorrichtung besitzt einen Meßtransformator, der in mindestens einem Frequenzbereich ein annähernd lineares Frequenzverhalten aufweist. Alternativ ist eine Reihenschaltung von leistungselektronischen Schalteinrichtungen vorgesehen, die für ein Schalten der Spannung auf der Mittelspannungsebene ausgelegt sind. Ferner ist eine definierte Impedanz vorgesehen, die über ein Schaltelement sekundärseitig an den Meßtransformator oder die Reihenschaltung schaltbar ist. Erfindungsgemäß sind ferner ein Stromwandler und ein Spannungswandler vorgesehen, die mit dem Meßtransformator oder der Reihenschaltung verbunden sind.

Die erfindungsgemäße Vorrichtung setzt einen Meßtransformator ein, dessen Impedanz meßtechnisch bestimmt ist und somit aus den gewonnenen Meßergebnissen herausgerechnet wird. Alternativ zu dem Meßtransformator kann auch eine Reihenschaltung von leistungselektronischen Schalteinrichtungen vorgesehen werden, um den Strom aus dem Netz auf die definierte Impedanz zu schalten. Bei der erfindungsgemäßen Meßvorrichtung kann die Verwendung eines Meßtransformators als eine Messung auf der Niederspannungsseite vorgesehen sein, sodaß das zusätzliche Schaltelement nicht die volle Spannung aus der Mittelspannungsebene schalten muß. Bei der Reihenschaltung von leistungselektronischen Schalteinrichtungen erfolgt eine Messung auf der Mittelspannungsebene. Auch hier muß das zusätzliche Schaltelement nicht die gesamte Spannung der Mittelspannungsebene schalten, sondern kann entsprechend der vorgeschalteten Reihenschaltung von leistungselektronischen Schaltelementen ausgelegt werden.

Beiden Meßvorrichtungen ist gemeinsam, daß sie direkt an die Mittelspannungsebene angeschlossen werden, um die Netzimpedanz auf der Mittelspannungsebene zu messen. Wird das erfindungsgemäße Meßverfahren für eine Messung auf der Mittelspannungsseite verwendet, ist kein Meßtransformator erforderlich. In diesem Fall wird für das Schalten der definierten Impedanz an das Mittelspannungsnetz auf eine Reihenschaltung leistungselektronische Schaltelement wie beispielsweise IGBTs (insolated gate bipolar transistor) oder IGCTs (integrated gate commutator transistor) zurückgegriffen.

In einer bevorzugten Ausgestaltung sind der Stromwandler und der Spannungswandler bei der Messung auf der Niederspannungsseite sekundärseitig, d.h. auf der Mittelspannungsebene, an den Meßtransformator angeschlossen. Hierdurch entfällt die Berücksichtigung des Transformatoreinflusses auf das Meßergebnis. In einer alternativen Ausgestaltung ist es möglich, die Messung von Spannung und Strom auf der Niederspannungsseite durchzuführen. Meßtechnisch ist eine solche Messung einfacher realisierbar. Sie erfordert aber, wie bereits erwähnt, daß das Übertragungsverhalten des Meßtransformators genau bekannt ist und bei den Ergebnissen berücksichtigt wird.

Die Mittelspannungsebene des elektrischen Versorgungsnetzes, auf der die Messung der frequenzabhängigen Impedanz erfolgt, weist bevorzugt eine Spannung von 1 kV bis 60 kV auf.

Um bei der definierten Impedanz eine Frequenzverfälschung zu vermeiden und zugleich die Meßvorrichtung kompakt bauen zu können, werden Oxidkeramik-Widerstände eingesetzt. Insbesondere werden Oxidkeramik-Scheibenwiderstände eingesetzt, weil sie ein lineares Frequenzverhalten aufweisen, sehr kompakt und temperaturbeständig sind und neben dem ohm'schen Widerstand nur eine kleine Induktivität besitzen.

Für den Meßtransformator wird bevorzugt ein streuarmer Meßtransformator vorgesehen, der eine sehr schmale Hysteresekennlinie besitzt, um so in einem weiten Frequenzbereich ein lineares Übertragungsverhalten bereitzustellen.

Der Meßtransformator kann bevorzugt auch als ein dreiphasiger Pulswiderstand vorgesehen sein. Wenn der Meßtransformator eine ausreichend große Impedanz aufweist, muß keine zusätzliche Impedanz vorgesehen werden, sondern es reicht aus, den Stromfluß an dem Meßtransformator und den durch die Impedanz des Meßtransformators verursachten Spannungsabfall zu messen. Bei der Messung wird der Meßtransformator auf der Niederspannungsseite durch den schnell schaltenden Schalter für kurze Zeiträume kurzgeschlossen.

In einer bevorzugten Ausgestaltung ist die Meßvorrichtung als ein mobiles Gerät ausgebildet, das an einen Schaltschrank der Mittelspannung angeschlossen werden kann. Das mobile Gerät umfaßt den Meßtransformator, die Widerstände, die Schalteinrichtung, die Meßwandler und eine Auswerteeinrichtung.

Die erfindungsgemäße Aufgabe wird ebenfalls durch ein Verfahren zur Messung der Impedanz eines elektrischen Vorsorgungsnetzes auf der Mittelspannungsebene gelöst, das die Merkmale aus Anspruch 10 besitzt.

Das erfindungsgemäße Meßverfahren verwendet bei der Realisierung auf der Niederspannungsseite einen Meßtransformator, der die Spannung von der Mittelspannungsebene auf die Niederspannungsebene transformiert. Bei dem Meßverfahren wird eine definierte Impedanz auf der Niederspannungsebene gepulst geschaltet. Ein Stromwandler und ein Spannungswandler messen den durch den Stromfluß aus dem Netz erzeugten Spannungsabfall. Bevorzugt erfolgt die Strom- und die Spannungsmessung auf der Mittelspannungsebene, wobei die Meßeinrichtung sekundärseitig an den Meßtransformator angeschlossen ist. Bei einer Realisierung des Meßverfahrens auf Mittelspannungsebene wird die definierte Impedanz über eine Reihenschaltung von leistungselektronischen Schaltelementen an das Mittelspannungsnetz geschaltet.

Die Erfindung wird nachfolgend anhand von acht Figuren näher beschrieben.

Es zeigt:
- Fig. 1: ein Ersatzschaltbild zur Bestimmung der Netzimpedanz mit Meßtransformator,
- Fig. 2: eine einpolige Darstellung der Meßanordnung zur Bestimmung der Netzimpedanz mit Meßtransformator,
- Fig. 3: ein Ersatzbild zur Bestimmung der Netzimpedanz mit einem Schalter, bestehend aus mehreren leistungselektronischen Schalteinrichtungen in Reihe,
- Fig. 4: eine einpolige Darstellung der Meßanordnung zur Bestimmung der Netzimpedanz mit einem Schalter bestehend aus mehreren leistungselektronischen Schalteinrichtungen in Reihe, und
- Fig. 5: Schaltungstopologie bei einphasiger Messung mit IGBTs bei einer Schaltdauer über mehrere Netzspannungsperioden,
- Fig. 6: Schaltungstopologie bei dreiphasiger Messung mit IGBTs bei einer Schaltdauer über mehrere Netzspannungsperioden,
- Fig. 7: Schaltungstopologie bei einphasiger Messung mit IGBTs bei einer Schaltdauer über eine Netzspannungsperiode und
- Fig. 8: Schaltungstopologie bei einphasiger Messung mit IGCTs unabhängig von der Schaltungsdauer.

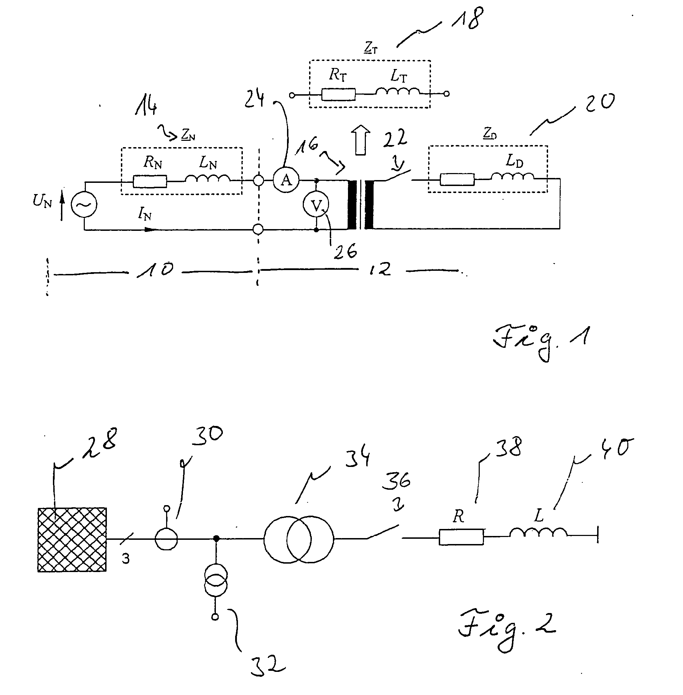

Fig. 1 zeigt ein Ersatzschaltbild für ein elektrisches Versorgungsnetz mit einem Mittelspannungsbereich 10 und einem Niederspannungsbereich 12, der sich im Meßgerät befindet. Auf der Mittelspannungsebene wird das elektrische Verhalten des Netzes durch die Netzimpedanz Z_{N} 14 gekennzeichnet. Widerstände, die durch komplexe Zahlen dargestellt werden, werden durch einen Unterstrich gekennzeichnet. An dem Netz liegt die Netzspannung U_{N} an und es fließt ein Netzstrom I_{N}. Auf der Niederspannungsseite 12 ist ein Meßtransformator 16 an das Mittelspannungsnetz angeschlossen. Der Meßtransformator 16 kann als komplexe Impedanz Z_{T} dargestellt werden, wie sie in 18 schematisch dargestellt ist. Über einen Leistungshalbleiter 22, beispielsweise einen IGBT, wird eine definierte Last 20 sekundärseitig an den Meßtransformator 16 geschaltet. Die definierte Impedanz Z_{D} 20 ist in Fig. 1 schematisch dargestellt und setzt sich aus einem ohm'schen Widerstand und einer Induktivität zusammen.

Die Messung erfolgt in dem in Fig. 1 dargestellten Ausführungsbeispiel primärseitig zu dem Meßtransformator durch einen Stromwandler 24 und einen Spannungswandler 26.

In einem Beispiel stellt sich der Meßvorgang wie folgt dar:

Auf der Mittelspannungsebene betrage die Spannung 10 kV, auf der Niederspannungsebene betrage die Spannung 400 V. Der Transformator ist entsprechend ausgelegt. Der Strom auf der 400-V-Ebene betrage 1000 Ampere und wird über ein IGBT gepulst auf die Widerstände 20 geschaltet. Hierbei tritt dann eine Kurzzeitleistung von 400 kW auf. Auf der 10-kV-Ebene beträgt der Strom 40 Ampere, die Kurzzeitleistung von 400 kW ist um die Transformatorverluste vermindert. Der Spannungsverlust auf der 10-kV-Ebene beträgt bei einer Impedanz von ungefähr 0,5 Ohm und 40 Ampere 20 V. Dieser Spannungsabfall wird gemessen und gibt Aufschluß über die Netzimpedanz.

Die Messung des Spannungsabfalls kann prinzipiell auf Mittel- oder Niederspannungsseite erfolgen. Die Auswertung der Meßsignale erfolgt unabhängig von der Spannungsebene. Durch das Ein- und Ausschalten der Widerstände entstehen Ströme der unterschiedlichen Frequenz, die dann frequenzabhängig analysiert werden. Bei der Auswertung der Signale werden die Frequenzen bis zu einer Höchstfrequenz, beispielsweise 25 kHz, ausgewertet.

Fig. 2 zeigt den Aufbau der Erfindung in der einpoligen Darstellung. Hierbei kennzeichnet 28 das Spannungsnetz, an das ein Stromwandler 30 und ein Spannungswandler 32 angeschlossen sind. Der Meßtransformator ist beispielsweise als 10/0,4 kV Transformator ausgelegt. Über ein IGBT 36 wird eine definierte Last bestehend aus ohm'schen Widerstand 38 und Induktivität 40 gepulst zugeschaltet.

Bei der definierten Last 20 bzw. 38, 40 handelt es sich beispielsweise um einen Oxidkeramik-Widerstand, der mehrere Oxidkeramik-Scheibenwiderstände aufweist.

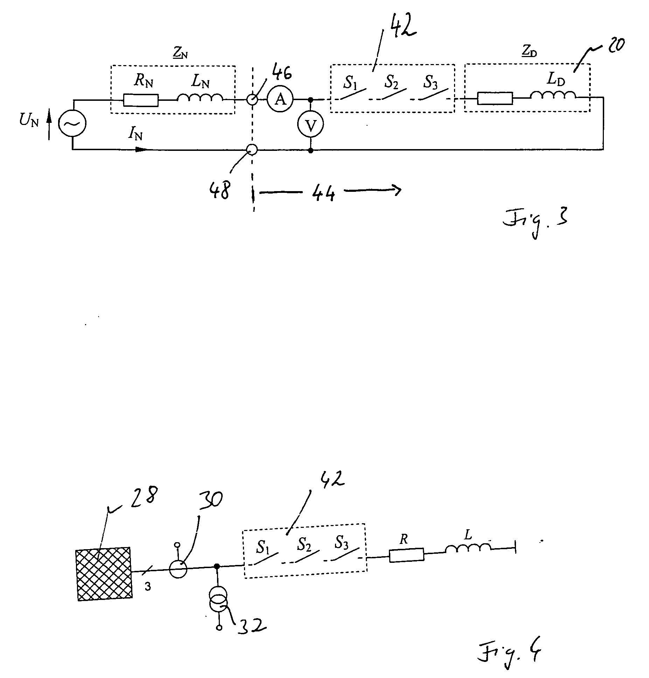

Figur 3 zeigt ein Ersatzschaltbild zur Bestimmung der Netzimpedanz unter Verwendung eines Schalters 42 bestehend aus mehreren leistungselektronischen Schalteinrichtungen S1, S2, S3. Wie bereits in Figur 1 ist das Meßgerät 44 in zwei Anschlußpunkten 46 und 48 an das Mittelspannungsnetz angeschlossen. Über den Schalter 42 wird die definierte Impedanz Z_{_D}20 an das Mittelspannungsnetz geschaltet. Die Schalter S1, S2 und S3 sind mit ihrer Sperrspannung für die Spannung des Mittelspannungsnetzes ausgelegt, sodaß diese in Reihe geschaltet die definierte Impedanz 20 anschließen können und Stromwandler 24 sowie Spannungswandler 26 die Auswirkung der definierten Impedanz auf das Mittelspannungsnetz messen können. Im Gegensatz zu der in Figur 1 dargestellten Meßanordnung erfolgt hierbei eine Messung auf der Mittelspannungsebene, ohne das zuvor die Spannung transformiert wurde.

Der in Figur 1 dargestellte Schalter 22 kann beispielsweise der in Figur 3 dargestellte Schalter S3 sein, sodaß die Schalter S1 und S2 die zusätzlichen Schaltelemente darstellen, die es ermöglichen, die Spannung auf Niveau der Mittelspannungsebene zu schalten.

Figur 4 zeigt die Meßanordnung aus Figur 3 in einer einpoligen Darstellung, wobei hier wieder mit 28 das Spannungsnetz, mit 30 der Stromwandler und mit 32 der Spannungswandler dargestellt ist.

Bevorzugt werden für die Schalter S1 bis S3 IGBTs oder IGCTs angewendet, die in ihrer Sperrspannung für die entsprechende Spannungsklasse ausgelegt sind.

Figur 5 zeigt einen einphasigen Mittelspannungsanschluß 50, der mit zwei Ästen eines Zweiwegegleichrichters 52 verbunden ist. Der Zweiwegegleichrichter 52 richtet die anliegende Spannung gleich, die dann über die Reihe geschaltete IGBTs 54 und 56 auf einen variablen Lastwiderstand 58 geschaltet wird. In Figur 5 sind lediglich zwei IGBTs 54 und 56 dargestellt. Der variable Lastwiderstand 58 entspricht der vordefinierten Impedanz.

Die IGBTs 54 und 56 besitzen standardmäßig herstellerseitig eine zusätzlich antiparallel geschaltete Diode 60, 62. Um die IGBTs zum richtigen Zeitpunkt schalten zu lassen, ist daher der Zweiwegegleichrichter 52 notwendig.

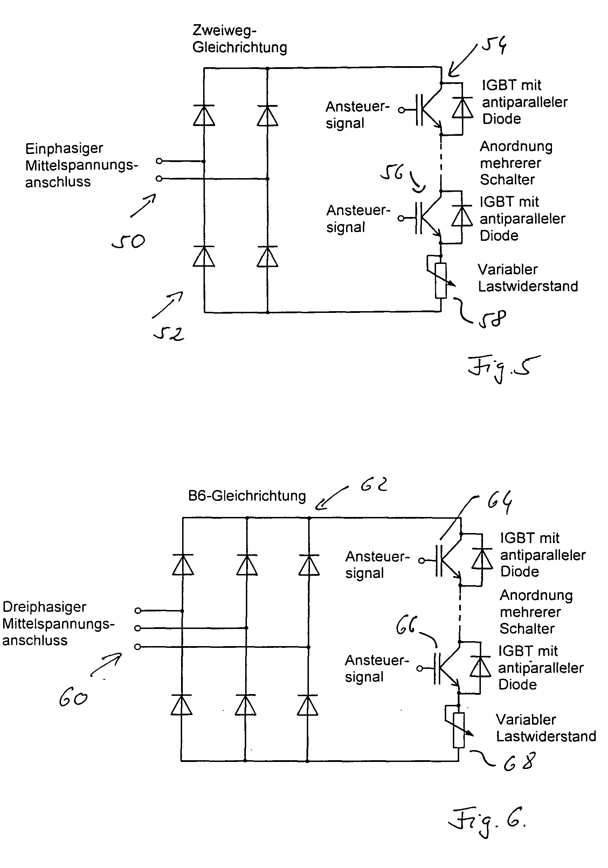

Figur 6 zeigt eine alternative Ausgestaltung für einen dreiphasigen Mittelspannungsanschluß 60, der über einen Gleichrichter 62 gleichgerichtet wird. Der Gleichrichter besitzt drei parallel geschaltete Äste mit jeweils entgegengesetzt gerichteten Dioden 64. Ein solcher Gleichrichter wird gelegentlich auch als B6-Gleichrichter bezeichnet. Die in Reihe geschalteten IGBTs 64, 66 werden auf den variablen Lastwiderstand 68 geschaltet.

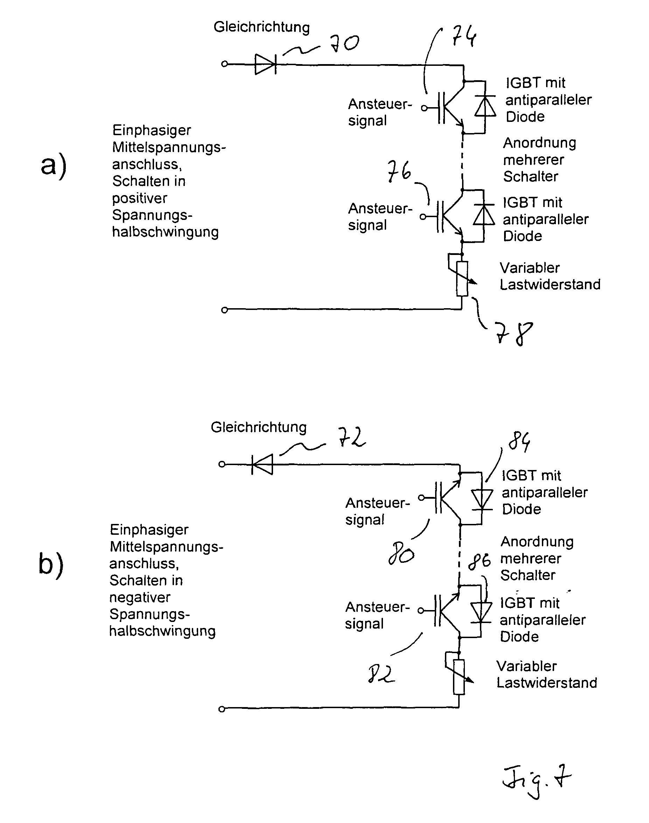

Eine einphasige Messung mit IGBTs über eine Netzspannungsperiode ist in Figur 7 dargestellt, wobei Figur 7a das Schalten in der positiven Spannungsschaltung und Figur 7b das Schalten während der negativen Spannungshalbschwingung zeigt. In Figur 7 wird die Mittelspannung pro Schaltzweig mit einem Einweg-Gleichrichter 70, 72 gleichgerichtet. In Figur 7a wird über die Reihenschaltung der IGBTs 74, 76 die gleichgerichtete Spannung auf den variablen Lastwiderstand 78 geschaltet. Bei der dargestellten Anordnung in Figur 7a sind die antiparallelen Dioden 80, 82 der IGBTs 74 und 76 der Gleichrichterdiode 70 entgegengesetzt gerichtet, um über die IGBTs schalten zu können.

Figur 7b zeigt den Mittelspannungsast bei entgegengesetzter Anordnung der IGBTs 80 und 82, die ebenfalls zu einer entgegengesetzten Anordnung der Dioden 84 und 86 führt.

Eine dreiphasige Messung mit IGBTs erfolgt durch eine dreifache Anordnung gemäß Figur 7a für die drei positiven Spannungshalbschwingungen und eine dreifache Anordnung gemäß Fig. 7b für die drei negativen Spannungshalbschwingungen.

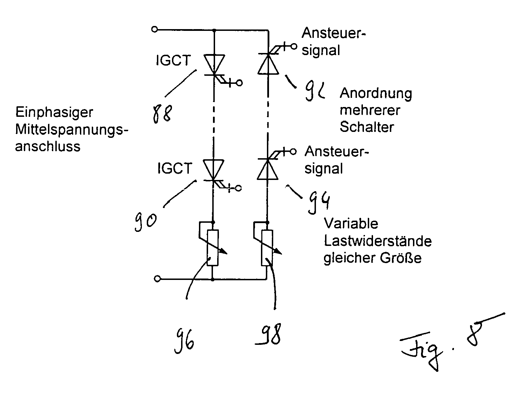

Figur 8 zeigt einen einphasigen Mittelanspannungsanschluß, bei dem über eine Reihe angeordnete IGCTs (integrated gate commutated thyristors) 88, 90 geschaltet wird. Die IGCTs sind in zwei parallelen Ästen mit entgegengesetzter Ausrichtung angeordnet. In jedem Ast befindet sich ein variabler Lastwiderstand 96 und 98, die jeweils die gleiche Größe besitzen.

Durch das Betätigen eines Schalters fließt ein Strom über einen Lastwiderstand. Das Ein- und Ausschalten (Pulsen) kann immer abhängig von der Sperrspannung der Schalter mit einem oder mehreren in Reihe liegenden Schalter erfolgen.

Der Schaltvorgang zur Erzeugung des Stromflusses muß für die positive und negative Halbschwingung der Spannung jeweils getrennt erfolgen, da die Polaritäten am Schalter sich dabei umkehren.

Dies läßt sich z.B. durch eine Schaltung mit IGBTs (Insulated Gate Bipolar Transistor) realisieren. Verfügbare Standardbauteile (IGBT-Module) beinhalten jedoch neben dem IGBT eine zusätzliche antiparallele Diode. Dadurch würde auch bei der Umkehr der Polarität am Schalter ein Strom fließen, der sich jedoch nicht schalten läßt. Deshalb muß bei der Verwendung von IGBTs eine Unterscheidung für die positive und negative Halbschwingung getroffen werden. Diese Unterscheidung wird durch eine Gleichrichtung möglich.

Die Dauer des Schaltvorgangs hängt von der Menge der Energiespeicher im Netz ab. Bei vielen Energiespeichern, d.h. großen Induktivitäten und Kapazitäten, dauert der abzuwartende Einschwingvorgang länger als bei wenigen bzw. kleineren Energiespeichern. Bei langen Einschwingvorgängen muß der Strom über den Zeitraum mehrerer Netzspannungsperioden fließen, bei kurzen Einschwingvorgängen reicht eine Spannungsperiode aus.

Abhängig davon müssen bei der Verwendung von IGBTs unterschiedliche Schaltungstopologien verwendet werden.

Bei langen Einschwingvorgängen und einphasiger Messung wird eine Schaltung gemäß Fig. 5 verwendet. Die Mittelspannung wird mit einer Zweiweg-Gleichrichtung gleichgerichtet. Mit der Schalterkombination wird auf der Gleichspannungsseite der variable Lastwiderstand gepulst.

Bei langen Einschwingvorgängen und dreiphasiger Messung wird eine Schaltung gemäß Fig. 6 verwendet. Die Mittelspannung wird mit einer B6-Gleichrichtung gleichgerichtet. Mit der Schalterkombination wird auf der Gleichspannungsseite der variable Lastwiderstand gepulst. Alternativ kann für dreiphasige Messungen auch eine dreifache Anordnung gemäß Fig. 5 genutzt werden.

Bei kurzen Einschwingvorgängen und einphasiger Messung über eine Netzspannungsperiode wird eine Schaltung gemäß Fig. 7 verwendet. Die Mittelspannung wird pro Schaltzweig mit einer Einweg-Gleichrichtung gleichgerichtet. Es sind eine gesonderte Schalterkombination und ein gesonderter variabler Lastwiderstand pro Spannungshalbschwingung erforderlich. Die Lastwiderstände werden gleich groß gewählt und jeweils auf der Gleichspannungsseite gepulst.

Eine dreiphasige Messung mit IGBTs über eine Netzspannungsperiode ist nur durch eine dreifache Anordnung gemäß Fig. 7 möglich.

Werden für den Schaltvorgang IGCTs (Integrated Gate Commutated Thyristor) genutzt, können diese in den Schaltungen der Fig. 5 bis Fig. 7 die IGBTs ersetzen. Zusätzlich ist mit ICGTs eine gesonderte Schaltungstopologie möglich. In Fig. 8 ist die Schaltung mit IGCTs bei einphasiger Messung abgebildet. Bei einer dreiphasigen Messung mit IGCTs ist die dreifache Anordnung gemäß Fig. 8 nutzbar. Beim Einsatz von IGCTs ist keine Unterscheidung der Schaltungen nach der Länge des Einschwingvorgangs notwendig.

Wegen der hohen Spannung im Mittelspannungsbereich von über 1 kV bis 60 kV müssen auch die Schalter selbst innerhalb des Meßgerätes gegeneinander isoliert werden. Die Auslegung der Isolation erfolgt auf der Grundlage von Teilentladungsmessungen. Mit diesen Teilentladungsmessungen wird der Grenzwert der Durchschlagspannung zwischen den Schaltern untereinander und zum Gehäuse des Meßgeräts bestimmt. Entsprechend dieses Meßwerts werden das Isoliermaterial und der Isolationsabstand festgelegt.

Ist die Netzimpedanz relativ hoch, genügt gemäß dem ohmschen Gesetz ein kleinerer Stromfluß zur Erzeugung eines meßbaren Spannungsabfalls. Bei sehr starren Netzen, d.h. bei Netzen mit geringem Innenwiderstand, muß ein höherer Stromfluß erzeugt werden. Deshalb dient der erste Meßvorgang der groben Bestimmung des Impedanzwertes. Dieser erste Meßwert ermöglicht die Wahl des einzustellenden Stromwertes. Dieser Stromwert wird durch den Lastwiderstand bestimmt. Der Lastwiderstand verfügt dazu über mehrere Abgriffe.

Beim direkten Schalten auf der Mittelspannungsebene ist die funktionsgerechte Auslegung und Dimensionierung des Einzelschalters bzw. der in Reihe liegenden Teilschalter Bestandteil der Erfindung.

Der Schalter bzw. jeder der in Reihe liegenden Teilschalter muß für die zu isolierende Sperrspannung ausgelegt sein. Gleichzeitig muß von den Schaltern ein Laststrom geführt werden können, der bei der aktuellen Impedanz des Mittelspannungsnetzes einen Spannungsabfall an der Netzimpedanz erzeugt.

## Patentansprüche

1. Vorrichtung zur Messung der Impedanz eines elektrischen Vorsorgungsnetzes (10, 28) auf der Mittelspannungsebene, die folgendes aufweist:
- einen Meßtransformator (16, 34), der in mindestens einem Frequenzbereich ein lineares Frequenzverhalten aufweist, oder
- eine Reihenschaltung mehrerer leistungselektronischer Schalteinrichtungen,
- eine Impedanz (20, 38, 40), die über ein zusätzliches Schaltelement (22, 36) sekundärseitig an den Meßtransformator (16, 34) oder die Reihenschaltung schaltbar ist, und
- einen Stromwandler (24, 30) und einen Spannungswandler (26, 32), die mit dem Meßtransformator (16, 34) oder der Reihenschaltung verbunden sind.

2. Vorrichtung nach Anspruch 1, **dadurch gekennzeichnet; daß** der Stromwandler (24, 30) und der Spannungswandler (26, 32) sekundärseitig an den Meßtransformator (16, 34) angeschlossen sind.

3. Vorrichtung nach Anspruch 1, **dadurch gekennzeichnet, daß** der Stromwandler (24, 30) und der Spannungswandler (26, 32) primärseitig an den Meßtransformator (16, 34) angeschlossen sind.

4. Vorrichtung nach einem der Ansprüche 1 bis 3, **dadurch gekennzeichnet, daß** das Mittelspannungsnetz eine Spannung von 1 kV bis 60 kV aufweist.

5. Vorrichtung nach einem der Ansprüche 1 bis 4, **dadurch gekennzeichnet, daß** die definierte Impedanz Oxidkeramik-Widerstände aufweist.

6. Vorrichtung nach einem der Ansprüche 1 bis 5, **dadurch gekennzeichnet, daß** der Meßtransformator eine schmale Hysteresekennlinie aufweist.

7. Vorrichtung nach einem der Ansprüche 1 bis 6, **dadurch gekennzeichnet, daß** der Meßtransformator als ein dreiphasiger Pulswiderstand ausgelegt ist.

8. Vorrichtung nach einem der Ansprüche 1 bis 7, **dadurch gekennzeichnet, daß** ein Gehäuse vorgesehen ist, in dem der Meßtransformator, die Impedanz, der Stromwandler und der Spannungswandler angeordnet sind.

9. Vorrichtung nach Anspruch 8, **dadurch gekennzeichnet, daß** das Gehäuse mit Mitteln zum Anschluß an einen Schaltschrank der Mittelspannungsebene ausgestattet ist.

10. Verfahren zur Messung der Impedanz eines elektrischen Versorgungsnetzes auf der Mittelspannungsebene, das über einen Meßtransformator auf die Niederspannungsebene transformiert, oder über eine Reihenschaltung von leistungselektronischen Schaltelementen geschaltet wird, das Verfahren weist folgende Schritte auf:
- eine definierte Impedanz wird an dem Meßtransformator oder die Reihenschaltung gepulst geschaltet,
- ein Stromwandler und ein Spannungswandler messen den durch den Stromfluß aus dem Netz erzeugten Spannungsabfall aus dem Netz.

11. Verfahren nach dem vorhergehenden Anspruch, **dadurch gekennzeichnet, daß** die Strom- und Spannungsmessung auf Mittelspannungsebene erfolgt.
